(19) Europäisches Patentamt

European Patent Office

Office européen des brevets

(11) **EP 1 662 551 A2**

(12) **EUROPEAN PATENT APPLICATION**

(43) Date of publication:
**31.05.2006 Bulletin 2006/22**

(51) Int Cl.:
*H01L 21/02* (2006.01)   *H01L 21/8247* (2006.01)
*H01L 27/115* (2006.01)

(21) Application number: **05022792.5**

(22) Date of filing: **19.10.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **24.11.2004 JP 2004339472**

(71) Applicant: **MATSUSHITA ELECTRIC INDUSTRIAL CO., LTD.**
**Kadoma-shi, Osaka 571-8501 (JP)**

(72) Inventors:
• **Hayashi, Shinichiro**
  **Takatsuki-shi,**
  **Osaka 569-1041 (JP)**
• **Nasu, Toru**
  **Kyoto-shi,**
  **Kyoto 604-8474 (JP)**

(74) Representative: **Grünecker, Kinkeldey,**
**Stockmair & Schwanhäusser**
**Anwaltssozietät**
**Maximilianstrasse 58**
**80538 München (DE)**

(54) **Capacitor insulating film for a semiconductor memory device and method for fabricating the same**

(57)    A capacitor insulating film (21) is composed of a ferroelectric film formed on a substrate and containing an element functioning as a crystal nucleus which allows the growth of a crystal in a random crystal orientation. A capacitor element (23), e.g. in a FeRAM device, comprising this capacitor insulating film (21) keeps a very good polarisation property upon miniaturisation.

FIG. 1A

EP 1 662 551 A2

## Description

## CROSS-REFERENCE TO RELATED APPLICATIONS

The teachings of Japanese Patent Application JP 2004-339472, filed November 24, 2004, are entirely incorporated herein by reference, inclusive of the specification, drawings, and claims.

## BACKGROUND OF THE INVENTION

The present invention relates to a capacitor insulating film made of a ferroelectric material, a method for fabricating the same, a capacitor element using a capacitor insulating film made of a ferroelectric material, a method for fabricating the same, a semiconductor memory device having a capacitor element using a capacitor insulating film made of a ferroelectric material, and a method for fabricating the same.

In recent years, vigorous research and development have been conducted on a ferroelectric film having a characteristic of spontaneous polarization with a view of commercializing a nonvolatile RAM capable of high-speed read/write operations at an unprecedentedly low voltage. To implement a megabit-class semiconductor memory device to be mounted on an LSI composed of a CMOS with a design rule of 0.18 $\mu$m or less, in particular, a capacitor element having a so-called stacked structure capable of providing a large capacitance but occupying only a small area need to be developed. In the case of fabricating a capacitor element having a three-dimensional stacked structure (hereinafter referred to as a 3-D stacked structure), it is further necessary to deposit a ferroelectric film as a capacitor insulating film on a lower electrode formed on an underlayer having a concave or convex configuration.

Because a power source voltage for an LSI composed of a CMOS with a design rule of 0.18 $\mu$m or less is not more than 2 V, an electric field to be applied to a ferroelectric film is required to be high enough. To achieve this purpose, the thickness of the ferroelectric film should be reduced to about 90 nm or less.

In the 3-D stacked structure, the capacitor insulating film composed of the ferroelectric film is required to be formed on the lower electrode having a stepped portion. This has created a demand for the commercialization of a method for forming the capacitor insulating film composed of the ferroelectric film using CVD technology which is excellent in step coverage. As a particular method for forming a capacitor insulating film composed of a ferroelectric film made of $ABi_2B_2O_9$ (wherein A represents Sr or Ba and B represents Nb or Ta) using metal organic chemical vapor deposition (MOCVD) technology, a method which will be described herein below is disclosed by way of example (see, e.g., Patent Document 1: Japanese Laid-Open Patent Publication No. HEI 09-110429).

Into a thermal CVD system, a gas obtained by evaporating or sublimating double-ethoxide or double-isopropoxide represented by $A[B(OR)_6]_2$ is introduced as the source material of A and B, while a gas obtained by sublimating, e.g., bismuth tertiary butoxide or bismuth tertiary pentoxide is introduced as the source material of bismuth (Bi). As a result, the source materials that have been introduced into the thermal CVD system are guided to a position over a heated substrate where they are decomposed and deposited. Thereafter, a thermal treatment is performed in an atmosphere containing ozone to form the capacitor insulating film composed of the ferroelectric film made of $ABi_2B_2O_9$.

Referring to an embodiment disclosed in Patent Document 1, a specific description will be given herein below to an example of a conventional method for forming a capacitor insulating film composed of a ferroelectric film using MOCVD technology.

The first source material vessel of a low-pressure thermal CVD system (under a total pressure of 6.65 x $10^{-3}$ Pa) is charged with 10 g of $Sr[Ta(OiPr)_6]_2$ (wherein OiPr represents an isopropyl group) and maintained at a constant temperature of 180 °C. Into the first source material vessel, argon is further introduced at a flow rate of 90 ml/min and sent to a thermal decomposition furnace with a vapor resulting from the sublimation of $Sr[Ta(OiPr)_6]_2$. At the same time, the second source material vessel of the low-pressure thermal CVD system (under a total pressure of 6.65 x $10^{-3}$ Pa) is charged with 10 g of $Bi[OC(CH_3)_2C_2H_5]_3$ and maintained at a constant temperature of 80 °C. Into the second source material vessel, argon is further introduced at a flow rate of 30 ml/min and sent to the thermal decomposition furnace with a vapor resulting from the sublimation of $Bi[OC(CH_3)_2C_2H_5]_3$. In the thermal decomposition furnace, a $Pt/SiO_2/Si$ substrate has been heated to a temperature of 320 °C. The two source gases mentioned above are mixed, introduced into the thermal decomposition furnace, and guided to a position over the substrate where the source gas mixture is decomposed and deposited for 20 minutes. Then, the temperature is increased, while a gas mixture of 20 vol% ozone gas and 80 vol% oxygen gas is allowed to flow, so that a thermal process is performed at 750 °C for 30 minutes. Consequently, a capacitor insulating film composed of a ferroelectric film with a thickness of 250 nm is formed on the substrate.

It is disclosed that, as a result of analyzing the crystal structure of the capacitor insulating film composed of the ferroelectric film formed by the foregoing conventional method using an XRD (X-Ray Diffractometer), the crystals composing the ferroelectric film were $SrBi_2Ta_2O_9$. It is also disclosed that, as a result of analyzing a residual carbon component in the ferroelectric film, the amount of the carbon component is not higher than the level of detection sensitivity. A comparative example is further disclosed which used 100 vol% oxygen gas instead of the gas mixture of 20 vol% ozone gas and 80 vol% oxygen gas and performed otherwise the same operation as performed in the above-mentioned embodiment of Patent Document 1, with the result that a $SrBi_2Ta_2O_9$ film having a thickness of 250 nm was obtained and an extremely small amount of residual carbon was detected in the film.

However, a capacitor element having the capacitor insulating film composed of the ferroelectric film formed by the foregoing conventional method does not exhibit excellent properties. In the case where the thickness of the ferroelectric film is adjusted to 90 nm or less, in particular, the crystal orientation of the ferroelectric film shows a stronger tendency toward C-axis orientation so that a sufficient ferroelectric property is not obtainable. As a result of experiments, the present inventors have found the following fact, which will be described herein below in detail.

The conventional method has performed the deposition of the ferroelectric film primarily with a view to reducing the residual carbon in the ferroelectric film. When a thin ferroelectric film having a perovskite structure is deposited by performing the thermal process at 750 °C with respect to the substrate, crystal nuclei each serving as the base point of crystallization exist in the vicinity of the interface between the ferroelectric film and an underlying layer. Accordingly, the crystallization of the ferroelectric film occurs first in the portion of the ferroelectric film which is in contact with the underlying layer so that the $SrBi_2Ta_2O_9$ film having the stronger tendency toward crystal orientation in a C-axis direction, which is perpendicular to the underlying layer, is obtained. However, since the $SrBi_2Ta_2O_9$ film does not hold a polarization component in the C-axis direction, a sufficiently excellent ferroelectric property cannot be obtained.

As the ferroelectric film is thinner, the ratio of the thickness of the region of the ferroelectric film which is adjacent to the interface with the underlying layer to the total thickness of the ferroelectric film is accordingly higher so that the ratio of crystals in the C-axis orientation to all the crystals composing the $SrBi_2Ta_2O_9$ film is increased. This further degrades the ferroelectric property.

Thus, it has been difficult in accordance with the conventional method to provide a capacitor element which has been miniaturized and also has a sufficiently excellent polarization property. In other words, it has been difficult to provide a capacitor element which both allows a reduction in design rules and has excellent electric properties.

## SUMMARY OF THE INVENTION

In view of the foregoing, an object of the present invention is to provide a capacitor insulating film having a sufficiently excellent polarization property even when it is miniaturized. Another object of the present invention is to provide a capacitor element which allows a reduction in design rules and also has excellent electric properties and provide a semiconductor memory device having the capacitor element.

To attain the objects, a capacitor insulating film according to an aspect of the present invention is a capacitor insulating film composed of a ferroelectric film formed on a substrate and containing an element functioning as a crystal nucleus which allows growth of a crystal in a random crystal orientation.

In the capacitor insulating film according to the present invention, the ferroelectric film contains therein the element functioning as the crystal nucleus which allows the growth of the crystal in the random crystal orientation. As a result, crystal growth proceeds, as the base point, using the element functioning as the crystal nucleus contained in the ferroelectric film so that the crystal growth is immune to the influence of a film serving as an underlayer. Consequently, crystals composing the ferroelectric film formed through crystallization are not equally oriented in the C-axis direction but are oriented in random directions. In the growth of crystals, crystal growth, as the base points, using the crystal nuclei present within the ferroelectric film is predominant over crystal growth, as the base points, using crystal nuclei present in the portion of the ferroelectric film which is in contact with the underlying film. Accordingly, even when the ferroelectric film is thin, there is no such case where crystals in the C-axis orientation are predominant in the ferroelectric film. As a result, it becomes possible to implement a capacitor insulating film having a sufficiently excellent polarization property even when it is miniaturized. The effect described above is remarkably achieved particularly when a chemical vapor deposition process such as MOCVD (Metal Organic Chemical Vapor Deposition) or ALD (Atomic Layer Deposition) is used as a method for forming the capacitor insulating film composed of the ferroelectric film.

In the capacitor insulating film according to the aspect of the present invention, if the element functioning as the crystal nucleus is a carbon (C) element or a carbon compound composed of a carbon (C) element and one or more elements selected from the group consisting of a hydrogen (H) element, an oxygen (O) element, and a nitrogen (N) element, the crystal oriented in the random direction can be grown easily from the crystal nucleus.

In the capacitor insulating film according to the aspect of the present invention, an amount of the carbon (C) contained in the ferroelectric film is preferably not less than $1 \times 10^{18}/cm^3$ and not more than $1 \times 10^{21}/cm^3$.

The reason for preferring the values is that it is difficult to obtain a sufficient number of crystal nuclei within the ferroelectric film when the amount of the carbon contained in the ferroelectric film is less than the values, while the carbon remaining in the ferroelectric film may increase a leakage current and cause a dielectric breakdown when the amount of the carbon contained in the ferroelectric film is not less than the values.

In the capacitor insulating film according to the present invention, the ferroelectric film is preferably made of a ferroelectric material having a layered perovskite structure represented by the following chemical formula: $A_{m-1}S_2B_mO_{3m+3}$ (wherein A represents an element positioned at an A-site in the perovskite structure, B represents an element positioned at a B-site in the perovskite structure, S represents an element composing the layered structure, and m represents any of integers 2 to 5).

In the arrangement, the effect of improving the polarization property obtained by orienting the crystals composing the ferroelectric film in random directions is prominently observed.

In the capacitor insulating film according to the aspect of the present invention, a ratio of an X-ray diffraction peak intensity from, among C planes, a plane with a number of order where the X-ray diffraction peak intensity is highest to an X-ray diffraction peak intensity from a (1, 1, 2m+1) plane is preferably 1 or less in the ferroelectric film.

In the capacitor insulating film according to the aspect of the present invention, a crystal composing the ferroelectric film has a grain size not less than 50 nm and not more than 170 nm so that the voids between the crystals have been reduced. Since the C-axis orientation of the crystals composing the ferroelectric film is suppressed, the growth of a crystal having an abnormally large grain size, which is peculiar to a crystal in the C-axis orientation, has been suppressed. As a result, a ferroelectric film composed of crystals having reduced voids therebetween and grain sizes which are equal to a degree is implemented and the stress-migration resistance of the ferroelectric film is improved exponentially.

To solve the foregoing problems, a capacitor element according to an aspect of the present invention includes: a lower electrode formed on a substrate; a capacitor insulating film formed on the lower electrode; and an upper electrode formed on the capacitor insulating film, wherein the capacitor insulating film is composed of a ferroelectric film containing an element functioning as a crystal nucleus which allows growth of a crystal in a random crystal orientation.

Since the capacitor element according to the aspect of the present invention includes the capacitor insulating film according to the present invention which can achieve the effects mentioned above, the capacitor element having a sufficiently excellent polarization property even when it is miniaturized is implemented and the capacitor element which allows a reduction in design rules is implemented.

Preferably, the capacitor element according to the aspect of the present invention has a three-dimensional structure.

The arrangement makes it possible to implement a nonvolatile semiconductor memory device which has an extremely excellent data storage property and a large capacity but occupies only a small area. In particular, the capacitor insulating film composing the capacitor element having a three-dimensional structure and formed primarily by chemical vapor deposition has a sufficiently excellent polarization property even when it is miniaturized so that the capacitor element having a sufficiently excellent polarization property even when it is miniaturized is implemented.

Preferably, the capacitor element according to the aspect of the present invention further includes: an insulating film formed on the substrate and having a convex portion, wherein the lower electrode is formed along the convex portion of the insulating film and a ratio of a height of the convex portion from a bottom surface thereof to a top surface thereof to a width of the top surface of the convex portion is 1 or more.

The arrangement increases the surface area of the lower electrode so that an amount of charge which can be accumulated in the capacitor insulating film formed on the lower electrode is increased. As a result, a capacitor element having a large capacitance and an excellent polarization property is implemented.

Preferably, the capacitor element according to the aspect of the present invention further includes: an insulating film formed on the substrate and having a concave portion, wherein the lower electrode is formed along the concave portion of the insulating film and a ratio of a depth of the concave portion to an aperture diameter of the concave portion is 1 or more.

The arrangement increases the surface area of the lower electrode so that an amount of charge which can be accumulated in the capacitor insulating film formed on the lower electrode is increased. As a result, a capacitor element having a large capacitance and an excellent polarization property is implemented.

To attain the objects described above, a semiconductor memory device according to an aspect of the present invention includes: a transistor containing a source region and a drain region formed in a substrate; an interlayer insulating film formed on the substrate to cover the transistor; a plug formed in the interlayer insulating film to have a lower end thereof connected electrically to the source region or drain region of the transistor; and a capacitor element formed on the interlayer insulating film to have a bottom portion thereof connected electrically to an upper end of the plug, wherein the capacitor element is composed of a lower electrode formed on the substrate, a capacitor insulating film formed on the lower electrode, and an upper electrode formed on the capacitor insulating film and the capacitor insulating film is composed of a ferroelectric material containing an element functioning as a crystal nucleus which allows growth of a crystal in a random crystal orientation.

Since the semiconductor memory device according to the aspect of the present invention includes the capacitor element having the capacitor insulating film according to the present invention which can achieve the effects mentioned above, the nonvolatile semiconductor memory device which has an extremely excellent data storage property and a large capacity but occupies only a small area is implemented.

To attain the objects described above, a method for fabricating a capacitor insulating film according to an aspect of the present invention includes the steps of: forming a precursor film on a substrate by chemical vapor deposition; and crystallizing the precursor film to form the capacitor insulating film composed of a ferroelectric film in which a crystal is in a random crystal orientation, wherein the precursor film contains a carbon (C) element or a carbon compound composed of a carbon (C) element and one or more elements selected from the group consisting of a hydrogen (H) element, an oxygen (O) element, and a nitrogen (N) element.

The method for fabricating the capacitor insulating film according to the aspect of the present invention allows a crystal nucleus to be formed in the precursor film when it is formed by chemical vapor deposition such as, e.g., MOCVD or ALD. As a result, crystal growth proceeds by using, as the base point, the crystal nucleus present within the ferroelectric film when the ferroelectric film is formed by crystallizing the precursor film so that the crystal growth is immune to the influence of the film serving as the underlayer. Consequently, crystals composing the ferroelectric film formed through crystallization are not equally oriented in the C-axis direction but are oriented in random directions. In the growth of the crystals, crystal growth using, as the base points, the crystal nuclei present within the ferroelectric film is predominant over crystal growth using, as the base points, crystal nuclei present in the portion of the ferroelectric film which is in contact with the underlying film. Accordingly, even when the ferroelectric film is thin, there is no such case where crystals in the C-axis orientation are predominant in the ferroelectric film. This allows the fabrication of the capacitor insulating film having a sufficiently excellent polarization property even when it is miniaturized.

In the method for fabricating a capacitor insulating film according to the aspect of the present invention, the precursor film is preferably formed under a condition in which a temperature of the substrate is not less than 200 °C and not more than 300 °C.

The arrangement makes it possible to suppress the generation of a crystal nucleus in the portion of the precursor film which is in contact with the underlying film. As a result, crystal growth from the crystal nuclei present within the ferroelectric film is more likely to be predominant.

In the method for fabricating a capacitor insulating film according to the aspect of the present invention, the precursor film is preferably formed in a non-oxygen atmosphere.

In the arrangement, the carbon (C) composing the source material used for the chemical vapor deposition is more likely to remain in the precursor film. Accordingly, a sufficient number of crystal nuclei can be formed in the precursor film. In the case of using a source material made of an organic metal, the C (carbon) composing the organic metal is particularly likely to remain in the precursor film.

In the method for fabricating a capacitor insulating film according to the aspect of the present invention, an amount of the carbon contained in the precursor film is preferably not less than $1 \times 10^{19}/cm^3$ and not more than $1 \times 10^{22}/cm^3$.

In the arrangement, crystals oriented in random directions are more likely to be grown.

In the method for fabricating a capacitor insulating film according to the aspect of the present invention, the ferroelectric film is preferably made of a ferroelectric material having a layered perovskite structure represented by the following chemical formula: $A_{m-1}S_2B_mO_{3m+3}$ (wherein A represents an element positioned at an A-site in the perovskite structure, B represents an element positioned at a B-site in the perovskite structure, S represents an element composing the layered structure, and m represents any of integers 2 to 5).

In the arrangement, the effect of improving the polarization property obtained by orienting the crystals composing the ferroelectric film in random directions is prominently observed. Accordingly, it becomes possible to fabricate the capacitor insulating film having an excellent polarization property.

In the method for fabricating a capacitor insulating film according to the aspect of the present invention, a ratio of an X-ray diffraction peak intensity from, among C planes, a plane with a number of order where the X-ray diffraction peak intensity is highest to an X-ray diffraction peak intensity from a (1, 1, 2m+1) plane is preferably 1 or less in the ferroelectric film.

In the arrangement, those of the crystals composing the ferroelectric film which are oriented along crystal axes which develop large polarization are large in number so that the effect of improving the polarization property is prominently observed.

In the method for fabricating a capacitor insulating film according to the aspect of the present invention, a crystal composing the ferroelectric film has a grain size not less than 50 nm and not more than 170 nm so that the voids between the crystals have been reduced. Since the C-axis orientation of the crystals composing the ferroelectric film is suppressed, the growth of a crystal having an abnormally large grain size, which is peculiar to a crystal in the C-axis orientation, has been suppressed. As a result, a ferroelectric film composed of crystals having reduced voids therebetween and grain sizes which are equal to a degree is implemented and the stress-migration resistance of the ferroelectric film is improved exponentially.

A method for fabricating a capacitor element according to an aspect of the present invention includes the steps of: forming a lower electrode on a substrate; forming a precursor film on the lower electrode by chemical vapor deposition; and crystallizing the precursor film to form a capacitor insulating film composed of a ferroelectric film in which a crystal is in a random crystal orientation, wherein the precursor film contains a carbon (C) element or a carbon compound composed of a carbon (C) element and one or more elements selected from the group consisting of a hydrogen (H) element, an oxygen (O) element, and a nitrogen (N) element.

Thus, the method for fabricating a capacitor element according to the aspect of the present invention allows the fabrication of a capacitor insulating film having a sufficiently excellent polarization property even when it is miniaturized. Accordingly, a capacitor element having a sufficiently excellent polarization property even when it is miniaturized can be fabricated so that it becomes possible to implement the capacitor element which allows a reduction in design rules. If the lower electrode is made of platinum, in particular, the effect is prominently observed.

Preferably, the method for fabricating a capacitor element according to the aspect of the present invention further includes the step of forming an upper electrode on the precursor film after the step of forming the precursor film and prior to the step of forming the capacitor insulating film.

In the arrangement, the presence of the upper electrode on the precursor film suppresses a volume change in a direction toward the upper electrode resulting from crystal growth in which the precursor film is crystallized to form the ferroelectric film, compared with the case where the upper electrode is not present on the precursor film. This allows the suppression of roughness at the surface of the ferroelectric film and the suppression of an increase in leakage current. Accordingly, it becomes possible to implement a nonvolatile semiconductor memory device which has an extremely excellent data storage property and a large capacity but occupies only a small area.

In the method for fabricating a capacitor element according to the aspect of the present invention, the capacitor element preferably has a three-dimensional structure.

The arrangement makes it possible to implement a capacitor element having a sufficiently excellent polarization property even when it is miniaturized and thereby implement a nonvolatile semiconductor memory device which has an extremely excellent data storage property and a large capacity but occupies only a small area.

Preferably, the method for fabricating a capacitor element according to the aspect of the present invention further includes the step of forming an insulating film having a convex portion on the substrate prior to the step of forming the lower electrode, wherein the lower electrode is formed along the convex portion of the insulating film and a ratio of a height of the convex portion from a bottom surface thereof to a top surface thereof to a width of the top surface of the convex portion is 1 or more.

The arrangement increases the surface area of the lower electrode so that an amount of charge which can be accumulated in the capacitor insulating film formed on the lower electrode is increased. As a result, a capacitor element having a large capacitance and an excellent polarization property can be fabricated.

Preferably, the method for fabricating a capacitor element according to the aspect of the present invention further includes the step of forming an insulating film having a concave portion on the substrate prior to the step of forming the lower electrode, wherein the lower electrode is formed along the concave portion of the insulating film and a ratio of a depth of the concave portion to an aperture diameter of the concave portion is 1 or more.

The arrangement increases the surface area of the lower electrode so that an amount of charge which can be accumulated in the capacitor insulating film formed on the lower electrode is increased. As a result, a capacitor element having a large capacitance and an excellent polarization property can be fabricated.

In the method for fabricating a capacitor element according to the aspect of the present invention, the ferroelectric film is preferably made of a ferroelectric material having a layered perovskite structure represented by the following chemical formula: $A_{m-1} S_2 B_m O_{3m+3}$ (wherein A represents an element positioned at an A-site in the perovskite structure, B represents an element positioned at a B-site in the perovskite structure, S represents an element composing the layered structure, and m represents any of integers 2 to 5).

In the arrangement, the effect of improving the polarization property obtained by orienting the crystals composing the ferroelectric film in random directions is prominently observed. Accordingly, it becomes possible to fabricating a capacitor element having an excellent polarization property.

To attain the objects described above, a method for fabricating a semiconductor memory device according to an aspect of the present invention includes the steps of: forming a transistor having a source region and a drain region on a substrate; forming an interlayer insulating film on the substrate such that the transistor is covered therewith; forming, in the interlayer insulating film, a plug having a lower end thereof connected electrically to the source region or drain region of the transistor; and forming, on the interlayer insulating film, a capacitor element having a bottom portion thereof connected electrically to an upper end of the plug and the capacitor element is characterized in that it is formed by the method for fabricating a capacitor element according to the aspect of the present invention.

In accordance with the method for fabricating a semiconductor memory device according to the aspect of the present invention, the capacitor element composing the semiconductor memory device is formed in accordance with the method for fabricating a capacitor element according to the present invention which has the effects mentioned above. As a result, it becomes possible to implement the nonvolatile semiconductor memory device which has an extremely excellent data storage property and a large capacity but occupies only a small area.

Thus, the capacitor insulating film according to the aspect of the present invention and the fabrication method therefor allows crystal nuclei to be formed in the precursor film when it is formed by chemical vapor deposition such as, e.g., MOCVD or ALD. As a result, crystal growth proceeds using, as the base point, the crystal nucleus present within the ferroelectric film when the ferroelectric film is formed by crystallizing the precursor film so that the crystal growth is immune to the influence of the film serving as the underlayer. Consequently, crystals composing the ferroelectric film formed through crystallization are not equally oriented in the C-axis direction but are oriented in random directions. In the growth of crystals, crystal growth using, as the base points, the crystal nuclei present within the ferroelectric film is predominant over crystal growth using, as the base points, crystal nuclei present in the portion of the ferroelectric film which is in contact with the underlying film. Accordingly, even when the ferroelectric film is thin, there is no such case where crystals in the C-axis orientation are predominant in the ferroelectric film. This allows the fabrication of a capacitor insulating film having a sufficiently excellent polarization property even when it is miniaturized.

Since it is possible to implement a capacitor element having a sufficiently excellent polarization property even when it is miniaturized, a capacitor element which allows a reduction in design rules is implemented.

Further, a nonvolatile semiconductor memory device which has an extremely excellent data storage property and a large capacity but occupies only a small area is implemented.

**BRIEF DESCRIPTION OF THE DRAWINGS**

FIGS. **1** are principal-portion of cross-sectional views showing the structures of a semiconductor memory device according to a first embodiment of the present invention, of which FIG. **1A** shows a cross section along word lines and FIG. **1B** shows a cross section taken along the line **Ib-Ib** of FIG. **1A;**

FIGS. **2A** to **2D** are principal-portion of cross-sectional views illustrating process steps in a method for fabricating the semiconductor memory device according to the first embodiment;

FIGS. **3A** to **3D** are principal-portion of cross-sectional views illustrating the process steps in the method for fabricating the semiconductor memory device according to the first embodiment;

FIGS. **4A** to **4D** are principal-portion of cross-sectional views illustrating the process steps in the method for fabricating the semiconductor memory device according to the first embodiment;

FIGS. **5A** and **5B** are principal-portion of cross-sectional views illustrating the process steps in the method for fabricating the semiconductor memory device according to the first embodiment;

FIGS. **6A** and **6B** are schematic diagrams for illustrating the principle of the orientation of crystals composing a capacitor insulating film according to the first embodiment;

FIG. **7** is a graph showing the distribution of the grain sizes of the crystals composing the capacitor insulating film according to the first embodiment;

FIG. **8** is a principal-portion of cross-sectional view showing the structure of a semiconductor memory device according to a second embodiment of the present invention;

FIGS. **9A** to **9C** are principal-portion of cross-sectional views illustrating process steps in a method for fabricating the semiconductor memory device according to the second embodiment; and

FIGS. **10A** to **10C** are principal-portion of cross-sectional views illustrating the process steps in the method for fabricating the semiconductor memory device according to the second embodiment.

**DETAILED DESCRIPTION OF THE INVENTION**

Referring now to the drawings, the individual embodiments of the present invention will be described herein below.

EMBODIMENT 1

A description will be given herein below to a capacitor insulating film, a fabrication method therefor, a capacitor element using the capacitor insulating film, a fabrication method therefor, a semiconductor memory device using the capacitor insulating film, and a fabrication method therefor, each according to a first embodiment of the present invention with reference to the drawings.

The description will be given first to the respective structures of the capacitor insulating films, the capacitor elements comprising the capacitor insulating films, and the semiconductor memory devices comprising the capacitor insulating films, each according to the first embodiment with reference to the drawings.

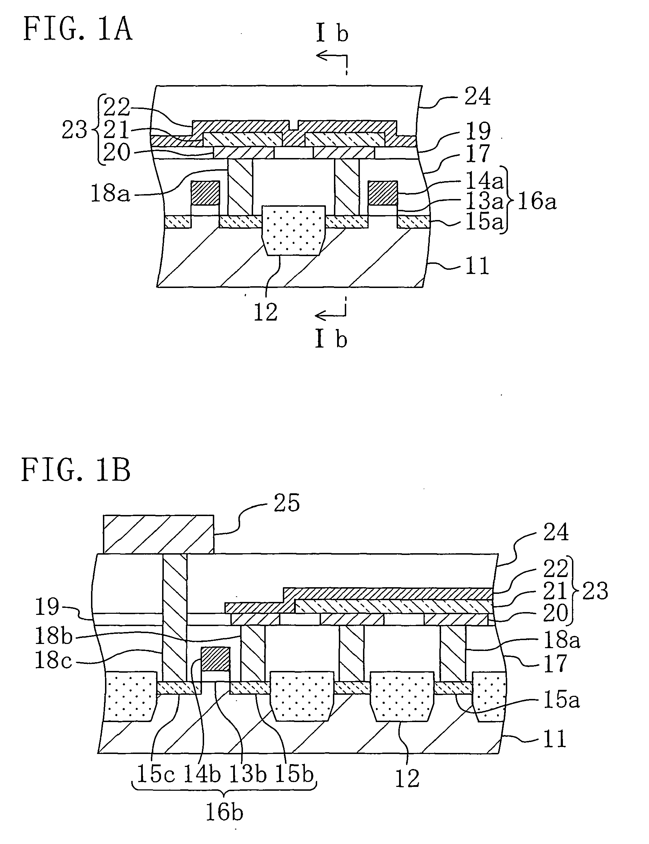

FIGS. **1A** and **1B** are cross-sectional views showing the structures of the capacitor insulating films, the capacitor elements using the capacitor insulating films, and the semiconductor memory devices using the capacitor insulating films, each according to the first embodiment, of which FIG. **1A** shows the cross-sectional structures in the direction along word lines and FIG. **1B** shows a cross section taken along the line **Ib-Ib** of FIG. **1A,** i.e., the cross-sectional structures along bit lines.

As shown in FIGS. **1A** and **1B,** memory cell transistors **16a,** transistors **16b** for memory-cell-plate drivers, and capacitor elements **23** are formed on a semiconductor substrate **11** made of silicon, which will be described in detail herein below

The memory cell transistors **16a** are formed on the element formation regions of the semiconductor substrate **11** partitioned by element isolation regions **12.** Each of the memory cell transistors **16a** is composed of a gate insulating film **13a** and a gate electrode 14a formed successively in ascending order on the semiconductor substrate **11** and of impurity diffusion regions **15b** formed in the surface layer portion of the semiconductor substrate **11**. The plurality of memory cell transistors **16a** are formed as a matrix along the word lines and the bit lines.

The transistors **16b** for memory-cell-plate drivers are formed on the element formation regions of the semiconductor substrate **11** partitioned by the element isolation regions **12**. Each of the transistors **16b** for memory-cell-plate drivers is composed of a gate insulating film **13b** and a gate electrode **14b** formed successively in ascending order on the semiconductor substrate **11** and of impurity diffusion regions **15b** and **15c** formed in the surface layer portion of the semiconductor substrate **11**. The transistors **16b** for memory-cell-plate drivers are formed at the distal ends of the memory cell transistors **16a** which are arranged in directions along the bit lines.

The element isolation regions **12** provide isolation between the individual memory cell transistors **16a,** between the individual transistors **16b** for memory-cell-plate drivers, and between the memory cell transistors **16a** and the transistors **16b** for memory-cell-plate drivers.

A first interlayer insulating film **17** composed of a silicon oxide film (BPSG film) having a thickness of 500 nm and doped with phosphorous or boron is formed over the semiconductor substrate **11** and the element isolation regions **12** to cover the memory cell transistors **16a** and the transistors **16b** for memory-cell-plate drivers. The plurality of capacitor elements **23** corresponding to the individual memory cell transistors **16a** are formed on the first interlayer insulating film **17**.

Each of the capacitor elements **23** is composed of: a lower electrode **20**; a capacitor insulating film **21**; and an upper electrode **22** which are formed successively in ascending order. The plurality of capacitor elements **23** are formed to be paired with the individual memory cell transistors **16a**. The lower electrode **20** is a multilayer film composed of a nitride (TiAlN) layer made of titanium and aluminum, an iridium (Ir) layer, and an iridium oxide ($IrO_2$) layer. The respective thicknesses of the individual layers are 100 nm, 50 nm, and 50 nm to 100 nm in ascending order. A platinum (Pt) layer having a thickness of about 100 nm may also be further stacked on the iridium oxide ($IrO_2$) layer. The lower electrode **20** also has a function as an oxygen barrier.

The lower electrodes **20** are electrically connected to the impurity diffusion layers **15a** of the memory cell transistors **16a** via first contact plugs **18a** formed in the first interlayer insulating film **17**. The lower electrodes **20** are provided independently for the individual capacitor elements **23**. A buried insulating film **19** composed of a silicon oxide film formed on the first interlayer insulating film **17** and having a thickness of 300 nm is formed between each adjacent two of the lower electrodes **20** so that the individual lower electrodes **20** are isolated from each other.

The capacitor insulating film **21** is made of

$SrBi_2Ta_2O_9$ (SBT) which is a ferroelectric material having a thickness of 90 nm. The upper electrode **22** is made of an iridium oxide ($IrO_2$) or platinum (Pt) film having a thickness of 50 nm. The capacitor insulating film **21** and the upper electrode **22** are formed as the common capacitor insulating film **21** and upper electrode **22** of the individual capacitor elements **23** arranged in the direction along any of the bit lines to be shared thereamong. The upper electrode **22** is formed directly over the lower electrodes **20** in the regions in which the capacitor insulating film **21** is not formed. The upper electrodes **22** are electrically connected to the impurity diffusion regions **15b** of the transistors **16b** for memory-cell-plate drivers via the lower electrodes **20** and second contact plugs **18b** formed in the first interlayer insulating film **17**.

A second interlayer insulating film **24** composed of a silicon oxide film ($O_3$-TEOS film) made with $O_3$ and TEOS and having a thickness of 300 nm is formed on the buried insulating films **19** to cover the capacitor elements **23**. An interconnect layer **25** containing aluminum (Al) is formed on the second interlayer insulating film **24**.

The interconnect layer **25** is electrically connected to the impurity diffusion regions **15c** of the transistors for memory-cell-plate drivers via third contact plugs **18c** made of tungsten which are formed to extend through the first and second interlayer insulating films **17** and **24** and the buried insulating films **19**.

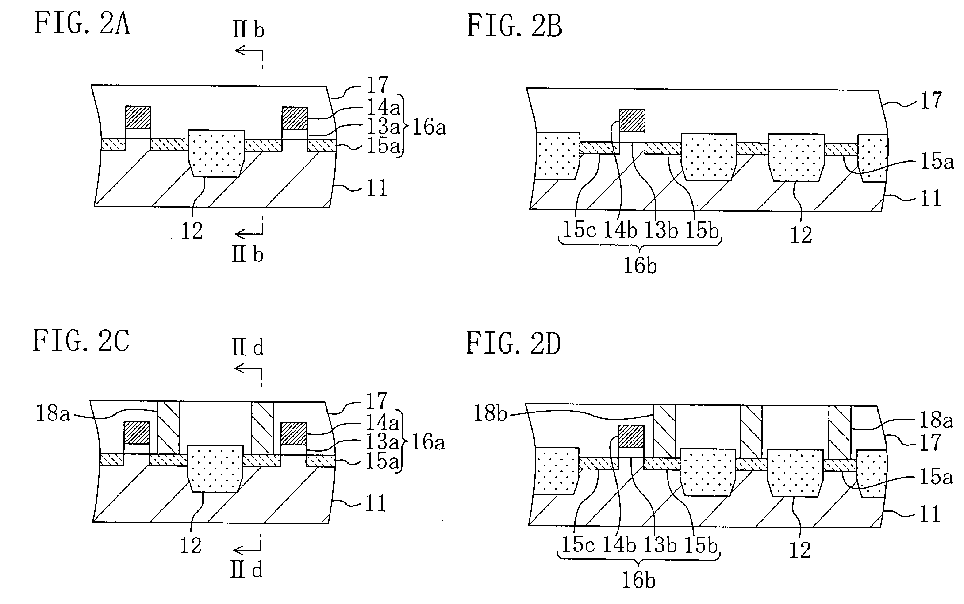

A description will be given second to a method for fabricating the capacitor insulating film, a method for fabricating the capacitor element using the capacitor insulating film, and a method for fabricating the semiconductor memory device using the capacitor insulating film, each according to the first embodiment with reference to FIGS. **2A** to **2D,** FIGS. **3A** to **3D,** FIGS. **4A** to **4D,** and FIGS. **5A** and **5B.**

FIGS. **2A** to **2D,** FIGS. **3A** to **3D,** FIGS. **4A** to **4D,** and FIGS. **5A** and **5B** are principal-portion of cross-sectional views illustrating the method for fabricating the capacitor insulating film, the method for fabricating the capacitor element using the capacitor insulating film, and the method for fabricating the semiconductor memory device using the capacitor insulating film, each according to the first embodiment, of which FIGS. **2A** and **2C,** FIGS. **3A** and **3C,** FIGS. **4A** and **4C,** and FIG. **5A** show cross sections along the word lines and FIGS. **2B** and **2D,** FIGS. **3B** and **3D,** FIGS. **4B** and **4D,** and FIG. **5B** show cross sections along the bit lines.

First, as shown in FIGS. **2A** and **2B** (which is the cross-sectional view taken along the line **IIb-IIb** of FIG. **2A**), the element isolation regions **12** each composed of the silicon oxide film is formed in the semiconductor substrate **11** made of silicon. Subsequently, the gate insulating films **13a** and **13b** and the gate electrodes **14a** and **14b** are formed successively in ascending order on the element formation regions of the semiconductor substrate **11** partitioned by the element isolation regions **12**. Then, the impurity diffusion layers **15a, 15b,** and **15c** are formed in the surface layer portion of the semiconductor substrate **11.** By the process described above, a specified number of memory cell transistors **16a** each composed of the gate insulating film **13a,** the gate electrode **14a,** and the impurity diffusion layers **15a** and a specified number of transistors **16b** for memory-cell-plate drivers each composed of the gate insulating film **13b,** the gate electrode **14b,** and the impurity diffusion layers **15b** and **15c** are formed along the bit lines and the word lines. Subsequently, the first interlayer insulating film **17** composed of the BPSG film is formed over the semiconductor substrate **11,** the impurity diffusion layers **15a**, **15b,** and **15c,** and the element isolation layers **12** to cover each of the memory cell transistors **16a** and the transistors **16b** for memory-cell-plate drivers.

Next, as shown in FIGS. **2C** and **2D** (which is the cross-sectional view taken along the line **IId-IId** of FIG. **2C),** etching is performed with respect to the first interlayer insulating film **17** to form first contact holes for exposing the impurity diffusion layers **15a** and second contact holes for exposing the impurity diffusion layers **15b.** Subsequently, tungsten is deposited in each of the first and contact holes and over the first interlayer insulating film **17.** Then, the portion of the deposited tungsten which is present on the first interlayer insulating film **17** is polished by CMP to form the plurality of first contact plugs **18a** and the plurality of second contact plugs **18b.**

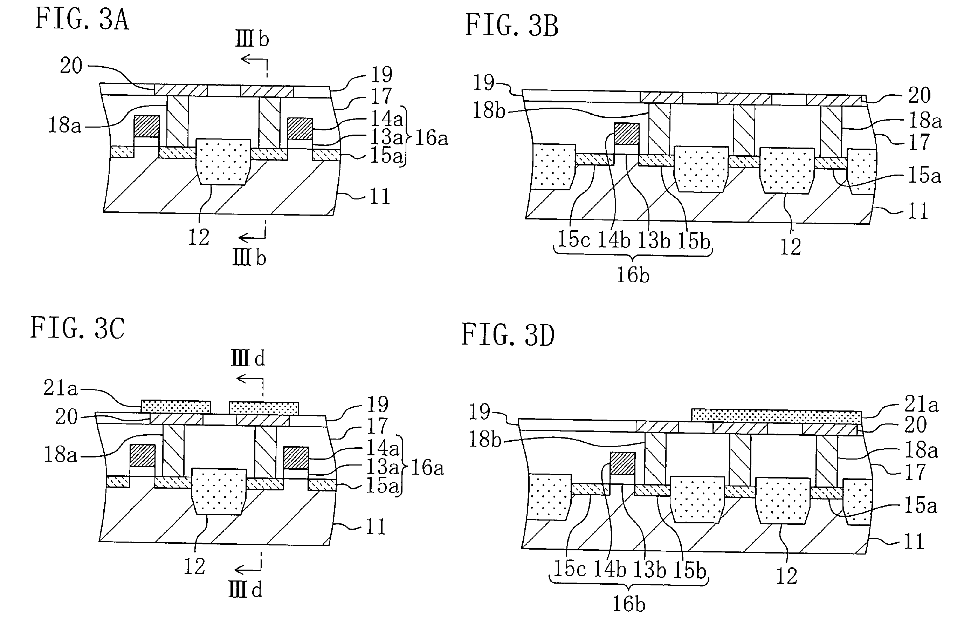

Next, as shown in FIGS. **3A** and **3B** (which is the cross-sectional view taken along the line **IIIb-IIIb** of FIG. **3A),** a multilayer film composed of a TiAlN layer with a thickness of 100 nm, an Ir layer with a thickness of 50 nm, and an $IrO_2$ layer with a thickness of 50 nm to 100 nm which are deposited successively in ascending order is formed over the first interlayer insulating film 17 to cover the respective upper surfaces of the first and second contact plugs **18a** and **18b** and then patterned to form the lower electrodes **20.** The $IrO_2$ layer is deposited herein by metal organic chemical vapor deposition (MOCVD). A Pt layer having a thickness of about 100 nm may also be further stacked on the $IrO_2$ layer. Subsequently, the buried insulating film **19** made of a silicon oxide is buried in each of the regions over the first interlayer insulating film **17** which is exposed between the individual lower electrodes **20.**

Next, as shown in FIGS. **3C** and **3D** (which is the cross-sectional view taken along the line **IIId-IIId** of FIG. **3C),** a precursor film **21a** made of SBT which is a ferroelectric material is formed by MOCVD over the buried insulating films **19** and the lower electrodes **20.** Then, the precursor film **21a** is patterned so that the lower electrodes **20** formed on the second contact plugs **18b** are exposed. A source material to be used in forming the precursor film **21a** by MOCVD may be selected appropriately from the group consisting of, e.g., $Sr[Ta(OC_2H_5)_5OC_2H_4OCH_3]_2$, $Ta(OC_2H_5)_5$, and $Bi[OC(CH_3)_2OCH_3]_3$.

The precursor film **21a** is formed to contain therein a C (carbon) element serving as a crystal nucleus or a carbon compound serving as a crystal nucleus. The carbon compound contained herein may be composed appropriately of a C (carbon) element and one or more elements selected from the group consisting of H (hydrogen), O (oxygen), and N (nitrogen).

Specifically, the precursor film **21a** containing the crystal nucleus mentioned above can be formed by depositing the precursor film **21a** by MOCVD in a state in which the substrate is, preferably, held at a temperature not less than 200 °C and not more than 300 °C.

More preferably, the deposition of the precursor film **21a** is performed in, e.g., an Ar or $N_2$ atmosphere not containing oxygen (a non-oxygen atmosphere) such that C is likely to remain in the film through the chemical reaction of an organic metal used as the source material of the precursor film **21a**.

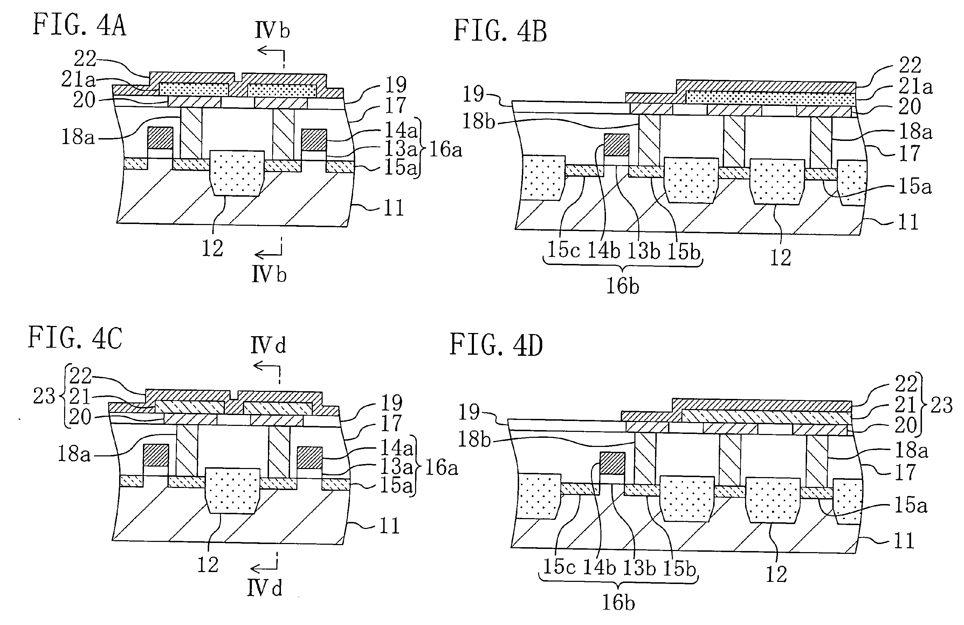

Next, as shown in FIGS. **4A** and **4B** (which is the cross-sectional view taken along the line **IVb-IVb** of FIG. **4A),** an $IrO_2$ film or a Pt film is deposited over the buried insulating films **19,** the precursor film **21a**, and the exposed lower electrodes **20.** Then, the deposited $IrO_2$ film or Pt film is patterned into a specified configuration to form the upper electrodes **22.** The $IrO_2$ film is deposited herein by MOCVD.

Next, as shown in FIGS. **4C** and **4D** (which is the cross-sectional view taken along the line **IVd-IVd** of FIG. **4C),** a thermal process which determines the density of crystal nuclei in the ferroelectric film is performed at a temperature not less than 600 °C and not more than 750 °C. Then, the precursor film **21a** is crystallized at a temperature of 800 °C to form the capacitor insulating films **21.** By the process described above, the capacitor elements **23** each composed of the lower electrode **20,** the capacitor insulating film **21,** and the upper electrode **22** are formed. The numeric range of crystal grain diameters (hereinafter referred to as grain sizes) is determined by the density of the crystal nuclei. By performing the thermal process in a temperature range of not less than 600 °C and not more than 750 °C, which was used herein to determine the density of the crystal nuclei, the grain sizes can be adjusted to a range of not less than 50 nm and not more than 170 nm. By setting the temperature range of not less than 650 °C and not more than 750 °C for the thermal process, the grain sizes can be adjusted to a range of not less than 50 nm and not more than 170 nm.

In the crystallization of the precursor film **21a,** the crystals composing the ferroelectric film is formed by crystal growth using the crystal nuclei present within the precursor film **21a** as the base points. In this case, the growth of the crystals is immune to the influence of the underlayer (the uppermost layer of each of the lower electrodes **20)** so that the crystals are oriented not equally in the C-axis direction but in random directions. The mechanism will be described later in detail.

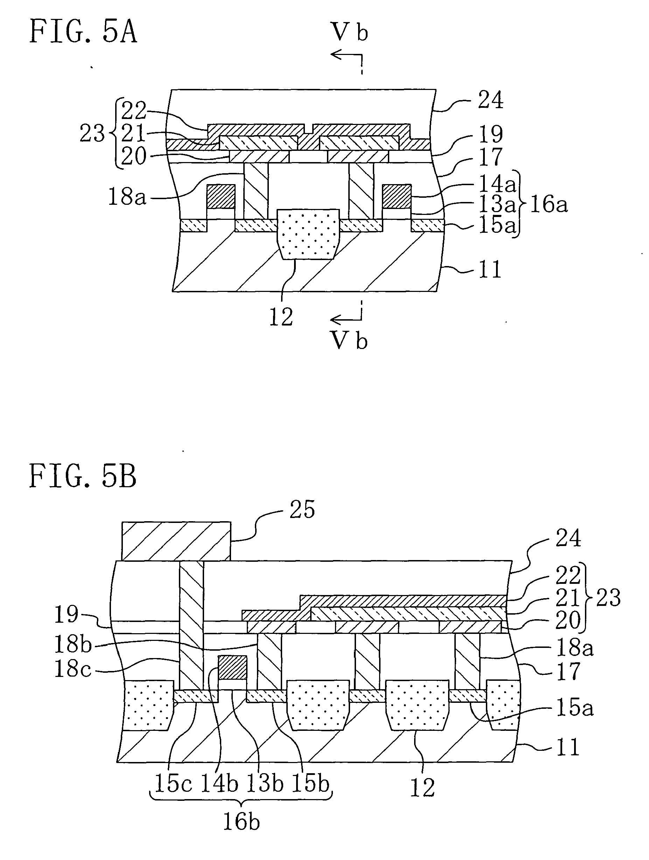

Next, as shown in FIGS. **5A** and **5B** (which is the cross-sectional view taken along the line **Vb-Vb** of FIG. **5A),** the second interlayer insulating film **24** composed of the $O_3$-TEOS film is formed over the upper electrodes **22** and the buried insulating film **19.** Then, etching is performed with respect to each of the second interlayer insulating film **24,** the buried insulating film **19,** and the first interlayer insulating film **17** to form third contact holes reaching the impurity diffusion regions **15c** of the transistors **16b** for memory-cell-plate drivers. Thereafter, tungsten is buried in the third contact holes to form the third contact plugs **18c.** Subsequently, the interconnect layer **25** containing aluminum is formed on the second interlayer insulating film **24** to come in contact with the third contact plugs **18c.**

Although the first embodiment of the present invention has connected the upper electrodes **22** to the second contact plugs **18b** by interposing the lower electrodes **20** therebetween, as shown in, e.g., FIG. **5B**, it is also possible to connect the upper electrodes **22** directly to the second contact plugs **18b** without interposing the lower electrodes **20** therebetween. However, since the annealing of the precursor film **21a** is performed in an oxygen atmosphere, the lower electrodes **20** having a function as an oxygen barrier are preferably interposed between the upper electrodes **22** and the second contact plugs **18b** to prevent the oxidation of the second contact plugs **18b** in terms of easier integration.

Although the transistors **16b** for the memory-cell-plate drivers are provided with a view to providing electrical connection between the upper electrodes **22** and the interconnect layer **25,** it is also possible to connect the second contact plugs **18b** and the third contact plugs **18c** to the same impurity diffusion regions without providing the transistors **16b** for the memory-cell-plate drivers, i.e., compose the impurity diffusion regions **15b** and the impurity diffusion regions **15c** of the same impurity diffusion regions.

As an element composing the ferroelectric film as the capacitor insulating film **21,** Ca or Ba may be used appropriately instead of Sr. Alternatively, any of Sr, Ca, and Ba may also be mixed at an arbitrary ratio. Instead of Ta, Nb or V may also be used. Alternatively, any of Ta, Nb, and V may also be mixed at an arbitrary ratio.

In the case of using the foregoing method, the formation of the second contact plugs **18b** can be performed simultaneously with the formation of the first contact plugs **18a.** This renders it possible to exclude the step of forming plugs providing direct connection between the upper electrodes **22** and the interconnect layer **25,** which causes the degradation of the ferroelectric property by hydrogen.

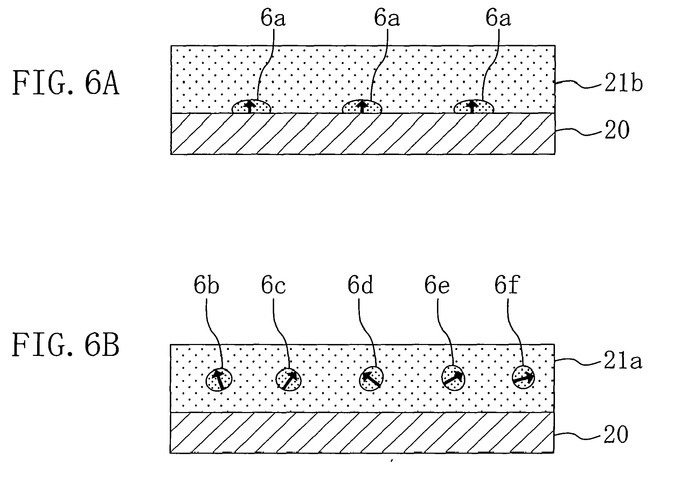

A detailed description will be given herein below to a method for forming the ferroelectric film composing the capacitor insulating film **21** such that the crystals in the ferroelectric film are oriented in random directions with reference to FIGS. **6A** and **6B.**

In the case of forming the precursor film **21a** made of a ferroelectric material by MOCVD, e.g., crystal growth using crystal nuclei as the base points occurs in the process of forming the capacitor insulating film **21** composed of the ferroelectric film by crystallizing the precursor film (ferroelectric material) **21a** so that the crystallization of the precursor film **21a** is performed. The crystal nuclei serving as the base points of crystal growth are present in the portions of the precursor film (ferroelectric material) **21a** which are in contact with the upper electrodes **22** or the lower electrodes **20.** If an impurity is contained in the ferroelectric material, the impurity functions as a crystal nucleus. Thus, crystal nuclei are present in the portion of the precursor film **21** which is in contact with a film made of a different material (different element).

First, as shown in FIG. **6A**, when the crystal nuclei are present in the portions of the precursor film **21b** which are in contact with the lower electrodes **20,** crystal growth using the crystal nuclei as the base points is likely to proceed in parallel with the underlayer (the uppermost layer of each of the lower electrodes **20**) so that crystals **6a** composing the ferroelectric material are likely to be oriented in the C-axis direction. By contrast, the crystal growth using the crystal nuclei present within the precursor **21a** as the base points has no restriction on the direction thereof so that crystals **6b** to **6f** are oriented in random directions, as shown in FIG. **6B**. Each of the arrows in FIG. **6A** indicates the C-axis direction.

During the deposition of the precursor film **21a** by MOCVD, if the substrate temperature is adjusted to be under 200 °C, the formation of the crystal nuclei is insufficient. If the substrate temperature is adjusted to be over 300 °C, by contrast, the crystal nuclei are likely to be formed in the portion of the precursor film **21a** which is in contact with the underlayer (the uppermost layer of each of the lower electrodes **20**). Accordingly, the substrate temperature when the precursor film **21a** is deposited by MOCVD is preferably held within a range of not less than 200 °C and not more than 300 °C.

A description will be given herein below to the result of evaluating the capacitor insulating films **21** each composed of the ferroelectric film in the first embodiment.

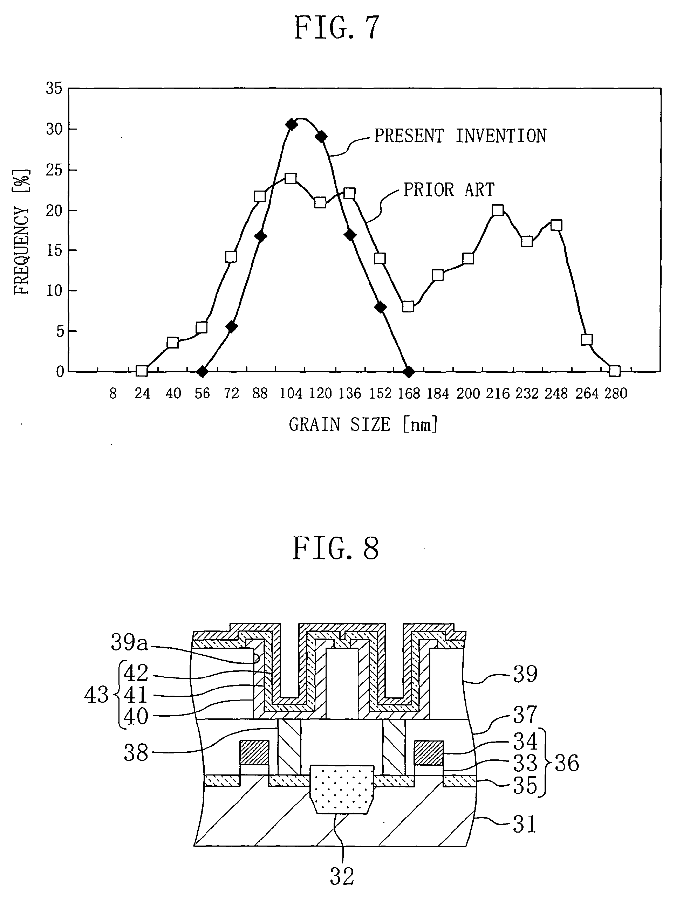

FIG. **7** shows the result of evaluating the distribution of the grain sizes of the crystals composing the ferroelectric film when an amount of C (carbon) contained in the capacitor insulating film **21** is adjusted to 5 x $10^{21}$/cm$^3$ (the amount of C (carbon) contained in the precursor film **21a** is 5 x $10^{22}$/cm$^3$). FIG. **7** also shows the result of similarly evaluating a ferroelectric film (capacitor insulating film) produced in accordance with the conventional method for comparison. The amount of C (carbon) in the ferroelectric film produced in accordance with the conventional method was under the limit of detection. The amount of C (carbon) was evaluated herein by secondary ion mass spectrometry (SIMS). The distribution of the grain sizes of crystals composing the ferroelectric film was evaluated by obtaining scanning electron micrographs (SEMs) of the cross sections of the ferroelectric films.

As will be appreciated from FIG **7,** the distribution of the grain sizes in the ferroelectric film produced in accordance with the conventional method apparently includes two distributions based on a broad categorization. It has been proved that the distribution of larger grain sizes corresponds to the distribution of crystals in the C-axis orientation, while the distribution of smaller grain sizes corresponds to the distribution of crystals oriented in random directions.

By contrast, the distribution of the grain sizes in the ferroelectric film according to the first embodiment of the present invention is apparently one distribution, as will also be appreciated from FIG. **7.** It has been proved that the distribution of the grain sizes corresponds to the distribution of crystals oriented in random directions.

The following is a description which can be given to the relationship between grain sizes and crystal orientation based on the foregoing results of evaluation.

In the first embodiment, the precursor film **21** contains therein a C (carbon) element or a carbon compound serving as a crystal nucleus so that, when the capacitor insulating film **21** is formed by performing a thermal process with respect to the precursor film **21a,** crystal growth from within the precursor film **21a** is predominant in the growth of crystals using the crystal nuclei within the precursor film **21** as the base points. Since the crystal growth from within the precursor film **21a** is thus predominant in the growth of crystals each from the C (carbon) element or the carbon compound serving as the crystal nucleus, the speed of the crystal growth is not restricted by an underlying electrode or the like and can therefore be considered to be higher than the speed of the crystal growth from the crystal nuclei present in the vicinity of the electrode. As a result, the growth of crystals oriented in random directions occurs. Accordingly, the growth of an abnormally large crystal, which is peculiar to a crystal oriented in the C-axis direction, is suppressed in the case of forming the ferroelectric film according to the first embodiment. From this, it will be understood that the grain sizes are distributed in a range of not less than 50 nm and not more than 170 nm where the crystals are oriented in random directions, as shown in FIG. 7. From the distribution of the grain sizes in a range of not less than 50 nm and not more than 170 nm, it will be understood that cavities (voids) between the crystals have been reduced and the growth of a crystal having an abnormally large grain size, which is peculiar to a crystal oriented in the C-axis direction, has been suppressed. As a result, a ferroelectric film composed of crystals having reduced voids therebetween and grain sizes which are equal to a degree is implemented and the stress-migration resistance of the ferroelectric film is improved exponentially.

A description will be given herein below to the result of measuring the orientation of crystal axes in the capacitor insulating film (ferroelectric film) according to the first embodiment by X-Ray diffractometry. The measurement by X-Ray diffractometry was performed using a Cu wire under such conditions that an acceleration voltage was 45 kV and an acceleration current was 40 mA.

The measurement was performed for $SrBi_2Ta_2O_9$ composing the capacitor insulating film according to the first embodiment and the ratio (X-ray diffraction intensity ratio (0, 0, 10)/(1, 1, 5)) of an X-ray diffraction peak intensity from the (0, 0, 10) plane, which is a plane with a number of order where the X-ray diffraction peak intensity is highest among C planes, to an X-ray diffraction peak intensity from the (1, 1, 5) plane was 1 or less. From the result, it will be understood that the C-axis orientation is suppressed in the capacitor insulating film according to the first embodiment and a large number of crystals oriented along crystal axes which develop large polarization are contained therein.

Thus, in the capacitor insulating film according to the first embodiment and the fabrication method therefor, crystal nuclei are formed within the precursor film **21a** when it is formed by chemical vapor deposition such as MOCVD or ALD. This allows the capacitor insulating film composed of a ferroelectric film to be formed by crystal growth using the crystal nuclei formed within the precursor film **21a** as the base points when the precursor film **21a** is crystallized. In this case, the crystal growth is immune to the influence of the underlayer (the uppermost layer of each of the lower electrodes **20**), as described above. As a result, crystals can be oriented, not equally in the C-axis direction, but in random directions. As described above, the crystal growth using, as the base points, the crystal nuclei present within the precursor film **21a** is predominant over the crystal growth using, as the base points, the crystal nuclei present in the portions of the lower electrode **20** serving as the underlayer which are in contact with the precursor film **21a.** Accordingly, even in the case of fabricating the capacitor insulating film **21** composed of a thin ferroelectric film, there is no such case where crystals oriented in the C-axis direction are predominant in the capacitor insulating film **21.** As a result, the capacitor insulating film **21** having a sufficiently excellent polarization property even when it is miniaturized can be implemented. In addition, the capacitor element **23** having a sufficiently excellent polarization property even when it is miniaturized can also be implemented so that it becomes possible to implement the capacitor element **23** which allows a reduction in design rules. Furthermore, a nonvolatile semiconductor memory device which has an extremely excellent data storage property and a large capacity but occupies only a small area can be implemented.

Although the present embodiment has described the case where the amount of C (carbon) contained in the precursor film **21a** has been adjusted to 5 x $10^{22}$/cm$^3$ (the amount of C (carbon) contained in the capacitor insulating film **21** is 5 x $10^{21}$/cm$^3$, the same effects as achieved by the present embodiment are achievable by adjusting the amount of C (carbon) contained in the precursor film **21a** to a range of not less than 1 x $10^{19}$/cm$^3$ and not more than 1 x $10^{22}$/cm$^3$ (the amount of C (carbon) contained in the capacitor insulating film **21** is adjusted to a range of not less than 1 x $10^{18}$/cm$^3$ and not more than 1 x $10^{21}$/cm$^3$). If the amount of C (carbon) is less than 1 x $10^{19}$/cm$^3$, it is difficult to obtain a sufficient number of crystal nuclei in the precursor film **21a.** If the amount of C (carbon) is more than $1 \times 10^{22}/cm^3$, on the other hand, a leakage current increases due to C (carbon) remaining in the capacitor insulating film (ferroelectric film) so that a dielectric breakdown is more like to occur.

Accordingly, it becomes possible to implement a highly reliable capacitor element which allows the prevention of a fault resulting from an increased leakage current or a reduced breakdown voltage and has an excellent electro-migration resistance. As a result, a highly reliable semiconductor memory device which allows higher integration thereof can be implemented.

Although the present embodiment has described the case where the ferroelectric film composing the capacitor insulating film **21** is made of $SrBi_2Ta_2O_9$, it is also possible to use, as the capacitor insulating film **21,** a ferroelectric film having a layered perovskite structure represented by a chemical formula: $A_{m-1}S_2B_mO_{3m+3}$ (wherein A represents an element positioned at an A-site in the perovskite structure, B represents an element positioned at a B-site in the perovskite structure, S represents an element composing the layered structure, and m represents any of integers 2 to 5). The element represented by A may appropriately be one or more elements selected from the group consisting of Sr, Ca, Ba, Bi and Pb. The element represented by B may appropriately be one or more elements selected from the group consisting of Ti, Ta, Hf, V, W, Nb, and Zr. The element represented by S may appropriately be one or more elements selected from the group consisting of Y, Sc, La, Sb, Cr, and Tl.

In the present embodiment, the smoothness of the interface in the vicinity of the electrode is improved using a conductive oxide such as $IrO_2$, $RuO_2$, or $SrRuO_3$ in the portion of the upper electrode **22** or the lower electrode **20** which is in contact with the capacitor insulating film **21.** This also allows the suppression of the formation of crystal nuclei in the portions of the capacitor insulating film **21** which are in contact with the upper electrode **22** or the lower electrode **20.** Accordingly, the ferroelectric film composing the capacitor insulating film **21** contains a larger number of randomly oriented crystals and therefore the capacitor insulating film **21** having a more excellent ferroelectric property can be implemented.

EMBODIMENT 2

A description will be given herein below to a capacitor insulating film, a fabrication method therefor, a capacitor element using the capacitor insulating film, a fabrication method therefor, a semiconductor memory device using the capacitor insulating film, and a fabrication method therefor each according to a second embodiment of the present invention with reference to the drawings. The second embodiment will describe the case where capacitor elements each having a concave-type three-dimensional structure are formed as shown in FIG. **8,** which will be described later.

The description will be given first to the respective structures of the capacitor insulating films, the capacitor elements using the capacitor insulating films, and the semiconductor memory device using the capacitor insulating films, each according to the second embodiment with reference to the drawings.

FIG. **8** is a principal-portion of cross-sectional view showing the structures of the capacitor insulating films, the capacitor elements using the capacitor insulating films, and the semiconductor memory devices using the capacitor insulating films, each according to the second embodiment. The drawing shows the cross section of each of the structures along bit lines.

As shown in FIG. **8,** a pair of memory cell transistors **36** and capacitor elements **43** are formed on a semiconductor substrate **31** made of silicon.

The memory cell transistors **36** are formed on the element formation regions of the semiconductor substrate **31** partitioned by element isolation regions **32.** Each of the memory cell transistors **36** is composed of a gate insulating film **33** and a gate electrode **34** formed successively in ascending order on the semiconductor substrate **31** and of impurity diffusion regions **35** formed in the surface layer portion of the semiconductor substrate **31.** The individual memory cell transistors **36** are isolated from each other by the element isolation regions **32.**

A first interlayer insulating film **37** having a thickness of 500 nm and made of a silicon dioxide ($SiO_2$) or a silicon nitride (SiN) is formed over the semiconductor substrate **31** and the element isolation regions **32** to cover the memory cell transistors **36.** In the first interlayer insulating film **37,** plugs **38** made of tungsten are formed to extend therethrough. A second interlayer insulating film **39** made of a silicon dioxide ($SiO_2$) or a silicon nitride (SiN) and having a thickness of 300 nm is formed on the first interlayer insulating film **37.**

In the second interlayer insulating film **39,** openings **39a** for exposing the first interlayer insulating film **37** and the plugs **38** are formed. Lower electrodes **40** are formed to extend along the bottom and sidewall portions of the openings **39a.** Each of the lower electrodes **40** is composed of a single-layer film made of Ir, $IrO_2$, Ru, $RuO_2$, TiAlN, TaAlN, TiSiN, or TaSiN or of a multi-layer film containing at least one selected from the group consisting of Ir, $IrO_2$, Ru, $RuO_2$, TiAlN, TaAlN, TiSiN, or TaSiN. When the lower electrode **40** is composed of the multi-layer film, the lower electrode **40** preferably has a structure containing at least a lower-layer film composed of a film functioning as an oxygen barrier and an upper-layer film (the film in contact with the capacitor insulating film) made of a conductive metal oxide such as an $IrO_2$, $RuO_2$, or $SrRuO_3$. In this case, the thickness of the upper-layer film in contact with the capacitor insulating film **41** is preferably 10 nm to 200 nm.

A capacitor insulating film **42** composed of a ferroelectric film having a thickness of 12.5 nm to 90 nm and made of $(Bi_xLa_{1-x})_4Ti_3O_{12}$ (BLT: wherein x satisfies

$0 \leq x \leq 1$) is formed on the second insulating film **39** to cover the lower electrodes **40** formed in the openings **39a**.

An upper electrode **42** made of a conductive oxide such as $IrO_2$, $RuO_2$, or $SrRuO_3$ and having a thickness of 10 nm to 200 nm is formed on the capacitor insulating film **41.** Thus, the capacitor elements **43** each composed of the lower electrode **40,** the capacitor insulating film **41,** and the upper electrode **42** are formed and connected to the impurity diffusion layers **35** of the memory cell transistors **36** via the plugs **38.**

A description will be given second to a method for fabricating the capacitor insulating film, a method for fabricating the capacitor element using the capacitor insulating film, and a method for fabricating the semiconductor memory device using the capacitor insulating film, each according to the second embodiment.

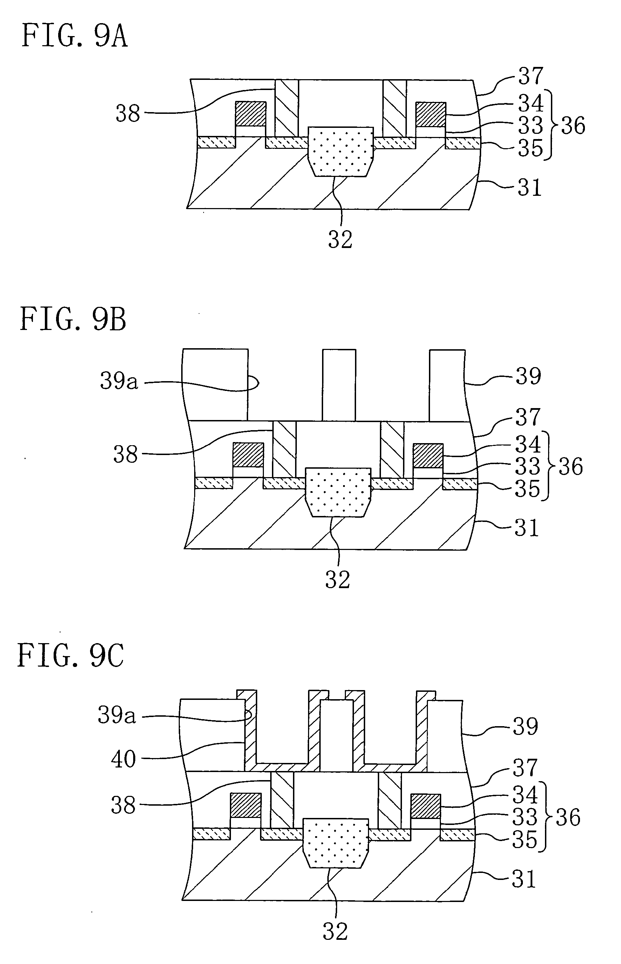

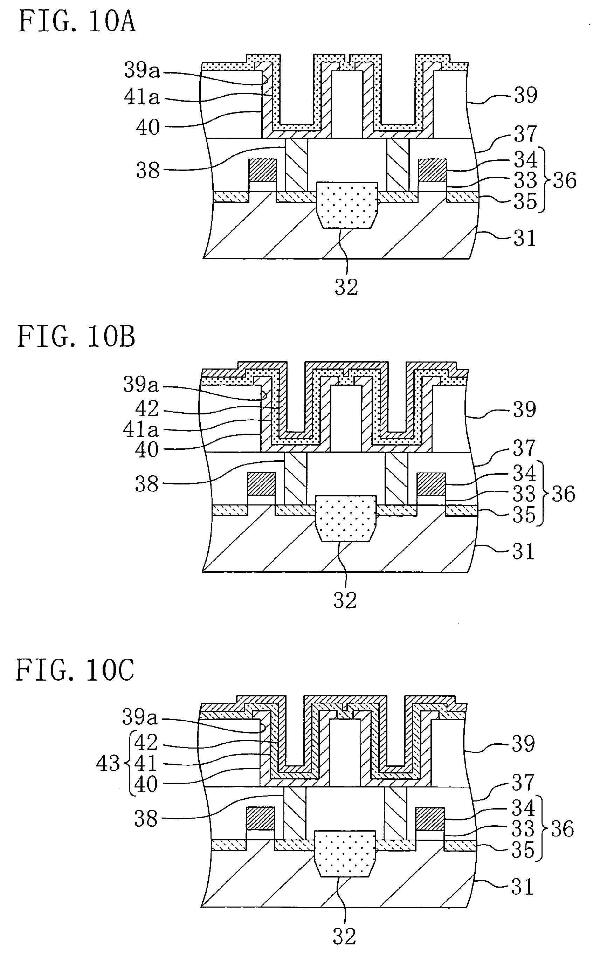

FIGS. **9A** to **9C** and FIGS. **10A** to **10C** are cross-sectional views illustrating the method for fabricating the capacitor insulating film, the method for fabricating the capacitor element using the capacitor insulating film, and the method for fabricating the semiconductor memory device using the capacitor insulating film, each according to the second embodiment

First, as shown in FIG. **9A,** the plurality of memory cell transistors **36** each composed of the gate insulating film **33** and the gate electrode **34** formed successively in ascending order on the semiconductor substrate **31** made of silicon and of the impurity diffusion layers **35** formed in the surface layer portion of the semiconductor substrate **31** are formed on the element formation regions of the semiconductor substrate **31** partitioned by the element isolation regions **32**. The plurality of memory cell transistors **36** are isolated from each other by the element isolation regions **32**. Then, the first interlayer insulating film **37** made of $SiO_2$ or SiN is formed over the semiconductor substrate **31** and the element isolation regions **32** to cover the memory cell transistors **36**. Subsequently, the plurality of plugs **38** made of tungsten extending through the first interlayer insulating film **37** and connected electrically to the impurity diffusion layers **35** of the individual memory cell transistors **36** are formed in the first interlayer insulating film.

Next, as shown in FIG. **9B,** the second interlayer insulating film **39** is formed over the first interlayer insulating film **37** and the plugs **38**. Then, the plurality of openings (concave portions) **39a** for exposing the individual plugs **38** are formed by etching the second interlayer insulating film **39**. Thus, the openings **39a** provided in the second interlayer insulating film **39** are holes for forming the capacitor elements **43,** which will be described later. Each of the diameters and depths of the openings **39a** may appropriately fall within the range of 0.2 μm to 1.0 μm. To maximize the surface area of each of the lower electrodes **40,** which will be described later, and thereby increase an amount of charge that can be accumulated, the ratio (depth/aperture ratio) of the depth of each of the openings **39a** to the aperture diameter thereof is preferably adjusted to 1 or more.

Next, as shown in FIG. **9C,** the lower electrodes **40** each made of a conductive metal oxide such as $IrO_2$, $RuO_2$, or $SrRuO_3$ are formed on the second interlayer insulating film **39** and on the bottom and sidewall portions of the openings **39a** to extend along the inner surfaces of the openings **39a** and come in contact with the plugs **38**. The upper layer made of the conductive metal oxide composing the lower electrodes **40** is deposited by MOCVD.

Next, as shown in FIG. **10A**, a precursor film **41a** made of $(Bi_xLa_{1-x})_4Ti_3O_{12}$ (wherein x satisfies $0 \leq x \leq 1$), which is a ferroelectric material, is deposited on the second interlayer insulating film **39** to cover the upper and side surfaces of the lower electrodes **40**. The deposition is performed by MOCVD featuring excellent step coverage under such a condition that the substrate temperature is 300 °C. A source material to be used in forming the precursor film **41a** by MOCVD may be selected appropriately from the group consisting of $La[OC(CH_3)_2CH_2OC_3H_7]_3$, $La(OC_2H_5)_3$, $Ti(OC_2H_5)_4$, $Ti[OC(CH_3)_2CH_2OC_3H_7]_4$, $Ti[OC(CH_3)_2CH_2OCH_3]_4$, $Bi(C_6H_5)_3$, and $Bi[OC(CH_3)_2CH_2OCH_3]_3$.

The precursor **41a** is formed to contain therein a C (carbon) element or a carbon compound serving as a crystal nucleus. The carbon compound may be composed appropriately of a C (carbon) element and one or more elements selected from the group consisting of H (hydrogen), O (oxygen), and N (nitrogen). The formation of the precursor film **41** containing such a crystal nucleus is implemented by depositing the precursor film **41a** by MOCVD in the state in which the substrate temperature is held in a range of not less than 200 °C and not more than 300 °C.

Preferably, the deposition of the precursor film **41** is performed in an atmosphere (non-oxygen atmosphere) made of, e.g., Ar or $N_2$ which does not contain oxygen such that C (carbon) is likely to remain through the chemical reaction of an organic metal serving as a source material.

Next, as shown in FIG. **10B**, the upper electrode **42** made of a conductive metal oxide such as $IrO_2$, $RuO_2$, or $SrRuO_3$ is formed by MOCVD on the precursor film **41a.**

Next, as shown in FIG. **10C,** the precursor film **41a** is crystallized by a thermal process to form the capacitor insulating films **41,** whereby the semiconductor memory devices shown in the drawing are completed.

The thickness of each of the capacitor insulating films **41** is adjusted to the range of 12.5 nm to 90 nm by controlling the time for the deposition of the precursor film **41a** by MOCVD. The grain sizes of crystals composing the ferroelectric film are adjusted to a range of not less than 50 nm and not more than 170 nm by depositing the precursor film **41a,** performing a thermal process which determines the density of crystal nuclei in a temperature range of, e.g., not less than 500 °C and not more than 650 °C, and then performing a thermal process at, e.g., 700 °C. Since the numeric range of the grain sizes is determined by the density of the crystal nuclei, the grain sizes can be adjusted to a range of not less than 50 nm and not more than 170 nm by performing the thermal process in a temperature range of not less than 500 °C and not more than 650 °C which was used herein to determine the density of the crystal nuclei. By setting a temperature range of not less than 600 °C and not more than 650 °C for the thermal process, the grain sizes can be adjusted reliably to a range of not less than 50 nm and not more than 170 nm. The grain size (crystal grain diameter) used herein indicates a longest diameter in an arbitrary cross section of the capacitor insulating film **41.** By providing grain sizes which are equal to a degree, it is also possible to further suppress the formation of voids which are cavities between crystals resulting from the different grain sizes of the individual crystals. Since the grain sizes are in a range of not less than 50 nm and not more than 170 nm, the cavities (voids) between the crystals have been reduced and the growth of a crystal having an abnormally large grain size, which is peculiar to a crystal oriented in the C-axis direction, has been suppressed. As a result, a ferroelectric film composed of crystals having reduced voids therebetween and grain sizes which are equal to a degree is implemented and the stress-migration resistance of the ferroelectric film is improved exponentially.

The orientation of crystal axes in the capacitor insulating film **41** according to the second embodiment was evaluated by X-Ray diffractometry in the same manner as in the first embodiment described above, with the result that the X-ray diffraction intensity ratio $(0, 0, 10)/(1, 1, 7)$ of $(Bi_xLa_{1-x})_4Ti_3O_{12}$ composing the capacitor insulating film **41** was 1 or less. From the result, it will be understood that the C-axis orientation is suppressed in the capacitor insulating film according to the second embodiment and a large number of crystals oriented along crystal axes which develop large polarization are contained therein.

In accordance with the method for fabricating a capacitor element according to the second embodiment, the same effects as achieved in the first embodiment are achievable even in a capacitor element having a three-dimensional structure in which a cross-sectional configuration is of concave type.

As a result, the C-axis orientation of crystals is suppressed during the crystallization of the precursor film **41a** and the ferroelectric film (capacitor insulating film **41)** made of randomly oriented crystals is formed so that the capacitor elements **43** excellent in ferroelectric property are formed. Accordingly, it becomes possible to implement a highly reliable capacitor element which allows the prevention of a fault resulting from an increased leakage current or a reduced breakdown voltage and has an excellent electro-migration resistance. As a result, a highly reliable semiconductor memory device which allows higher integration thereof can be implemented.

Although the present embodiment has described the case where the lower electrodes **40** each having a concave cross-sectional configuration are formed, the present invention is similarly applicable to the case where the lower electrodes **40** each having a convex cross-sectional configuration are formed. In this case, the ratio (height/width) of the height (distance) of the convex configuration from the bottom surface thereof to the top surface thereof to the width of the top surface of the convex configuration is 1 or more

Although each of the first and second embodiments has described the case where the capacitor insulating film is used to compose the capacitor element, the capacitor insulating film may also be used as a gate insulating film provided under the gate electrode of a ferroelectric FET or the like.

Although each of the first and second embodiments described above has used the metal organic chemical vapor deposition (MOCVD) as the method for forming the ferroelectric film featuring excellent step coverage, the same effects as achieved by the present invention are also achievable even when an ALD process is used.

Thus, the capacitor insulating film, the capacitor element, and the semiconductor memory device according to an aspect of the present invention has a capacitor insulating film made of a ferroelectric material having a sufficiently excellent polarization property so that an excellent data storage property is implemented. Hence, the present invention is useful for a capacitor element comprising a capacitor insulating film made of a ferroelectric material and a semiconductor memory device using the capacitor insulating film.

**Claims**

1. A capacitor insulating film composed of a ferroelectric film formed on a substrate and containing an element functioning as a crystal nucleus which allows growth of a crystal in a random crystal orientation.

2. The capacitor insulating film of claim 1, wherein the element functioning as the crystal nucleus is a carbon (C) element or a carbon compound composed of a carbon (C) element and one or more elements selected from the group consisting of a hydrogen (H) element, an oxygen (O) element, and a nitrogen (N) element.

3. The capacitor insulating film of claim 2, wherein an amount of the carbon (C) contained in the ferroelectric film is not less than $1 \times 10^{18}/cm^3$ and not more than $1 \times 10^{21}/cm^3$.

4. The capacitor insulating film of claim 1, wherein the ferroelectric film is made of a ferroelectric material having a layered perovskite structure represented by the following chemical formula:

$$A_{m-1}S_2B_mO_{3m+3}$$

(wherein A represents an element positioned at an A-site in the perovskite structure, B represents an element positioned at a B-site in the perovskite structure, S represents an element composing the layered structure, and m represents any of integers 2 to 5).

5. The capacitor insulating film of claim 4, wherein a ratio of an X-ray diffraction peak intensity from, among C planes, a plane with a number of order where the X-ray diffraction peak intensity is highest to an X-ray diffraction peak intensity from a (1, 1, 2m+1) plane is 1 or less in the ferroelectric film.

6. The capacitor insulating film of claim 5, wherein a crystal composing the ferroelectric film has a grain size not less than 50 nm and not more than 170 nm.

7. A capacitor element comprising:

   a lower electrode formed on a substrate;
   a capacitor insulating film formed on the lower electrode; and
   an upper electrode formed on the capacitor insulating film, wherein
   the capacitor insulating film is composed of a ferroelectric film containing an element functioning as a crystal nucleus which allows growth of a crystal in a random crystal orientation.

8. The capacitor element of claim 7, which has a three-dimensional structure.

9. The capacitor element of claim 8, further comprising:

   an insulating film formed on the substrate and having a convex portion, wherein
   the lower electrode is formed along the convex portion of the insulating film and
   a ratio of a height of the convex portion from a bottom surface thereof to a top surface thereof to a width of the top surface of the convex portion is 1 or more.

10. The capacitor element of claim 8, further comprising:

   an insulating film formed on the substrate and having a concave portion, wherein
   the lower electrode is formed along the concave portion of the insulating film and
   a ratio of a depth of the concave portion to an aperture diameter of the concave portion is 1 or more.

11. A semiconductor memory device, comprising:

   a transistor containing a source region and a drain region formed in a substrate;
   an interlayer insulating film formed on the substrate to cover the transistor;
   a plug formed in the interlayer insulating film to have a lower end thereof connected electrically to the source region or drain region of the transistor; and
   a capacitor element formed on the interlayer insulating film to have a bottom portion thereof connected electrically to an upper end of the plug, wherein
   the capacitor element is composed of a lower electrode formed on the substrate, a capacitor insulating film formed on the lower electrode, and an upper electrode formed on the capacitor insulating film and
   the capacitor insulating film is composed of a ferroelectric material containing an element functioning as a crystal nucleus which allows growth of a crystal in a random crystal orientation.

12. A method for fabricating a capacitor insulating film, the method comprising the steps of:

   forming a precursor film on a substrate by chemical vapor deposition; and
   crystallizing the precursor film to form the capacitor insulating film composed of a ferroelectric film in which a crystal is in a random crystal orientation, wherein
   the precursor film contains a carbon (C) element or a carbon compound composed of a carbon (C) element and one or more elements selected from the group consisting of a hydrogen (H) element, an oxygen (O) element, and a nitrogen (N) element.

13. The method of claim 12, wherein the precursor film is formed under a condition in which a temperature of the substrate is not less than 200 °C and not more than 300 °C.

14. The method of claim 13, wherein the precursor film is formed in a non-oxygen atmosphere.

15. The method of claim 12, wherein an amount of the carbon contained in the precursor film is not less than $1 \times 10^{19}/cm^3$ and not more than $1 \times 10^{22}/cm^3$.

16. The method of claim 12, wherein the ferroelectric film is made of a ferroelectric material having a layered perovskite structure represented by the following chemical formula:

$$A_{m-1}S_2B_mO_{3m+3}$$

(wherein A represents an element positioned at an A-site in the perovskite structure, B represents an element positioned at a B-site in the perovskite structure, S represents an element composing the layered structure, and m represents any of integers 2 to 5).

17. The method of claim 16, wherein a ratio of an X-ray diffraction peak intensity from, among C planes, a plane with a number of order where the X-ray diffraction peak intensity is highest to an X-ray diffraction peak intensity from a (1, 1, 2m+1) plane is 1 or less in the ferroelectric film.

18. The method of claim 12, wherein a crystal composing the ferroelectric film has a grain size not less than 50 nm and not more than 170 nm.

19. A method for fabricating a capacitor element, the method comprising the steps of:

forming a lower electrode on a substrate;
forming a precursor film on the lower electrode by chemical vapor deposition; and
crystallizing the precursor film to form a capacitor insulating film composed of a ferroelectric film in which a crystal is in a random crystal orientation, wherein
the precursor film contains a carbon (C) element or a carbon compound composed of a carbon (C) element and one or more elements selected from the group consisting of a hydrogen (H) element, an oxygen (O) element, and a nitrogen (N) element.

20. The method of claim 19, further comprising the step of forming an upper electrode on the precursor film after the step of forming the precursor film and prior to the step of forming the capacitor insulating film.

21. The method of claim 19, wherein the capacitor element has a three-dimensional structure.

22. The method of claim 21, further comprising the step of forming an insulating film having a convex portion on the substrate prior to the step of forming the lower electrode, wherein
the lower electrode is formed along the convex portion of the insulating film and
a ratio of a height of the convex portion from a bottom surface thereof to a top surface thereof to a width of the top surface of the convex portion is 1 or more.

23. The method of claim 21, further comprising the step of forming an insulating film having a concave portion on the substrate prior to the step of forming the lower electrode, wherein
the lower electrode is formed along the concave portion of the insulating film and
a ratio of a depth of the concave portion to an aperture diameter of the concave portion is 1 or more.

24. The method of claim 19, wherein the ferroelectric film is made of a ferroelectric material having a layered perovskite structure represented by the following chemical formula:

$$A_{m-1}S_2B_mO_{3m+3}$$

(wherein A represents an element positioned at an A-site in the perovskite structure, B represents an element positioned at a B-site in the perovskite structure, S represents an element composing the layered structure, and m represents any of integers 2 to 5).

25. A method for fabricating a semiconductor memory device, the method comprising the steps of:

forming a transistor having a source region and a drain region on a substrate;
forming an interlayer insulating film on the substrate such that the transistor is covered therewith;
forming, in the interlayer insulating film, a plug having a lower end thereof connected electrically to the source region or drain region of the transistor; and
forming, on the interlayer insulating film, a capacitor element having a bottom portion thereof connected electrically to an upper end of the plug, wherein
the step of forming the capacitor element includes the steps of forming a lower electrode on the substrate, forming a precursor film on the lower electrode by chemical vapor deposition, and crystallizing the precursor film to form a capacitor insulating film composed of a ferroelectric film in which a crystal is in a random crystal orientation, wherein
the precursor film contains a carbon (C) element or a carbon compound composed of a carbon (C) element and one or more elements selected from the group consisting of a hydrogen (H) element, an oxygen (O) element, and a nitrogen (N) element.

# FIG. 1A

# FIG. 1B

EP 1 662 551 A2

FIG. 2A

FIG. 2B

FIG. 2C

FIG. 2D

## FIG. 3A

20
19
17
18a
14a
13a } 16a
15a
11
12
IIIb
IIIb

## FIG. 3B

19
18b
20
18a
17
15a
11
15c 14b 13b 15b
16b
12

## FIG. 3C

21a
20
19
17
18a
14a
13a } 16a
15a
11
12
IIId
IIId

## FIG. 3D

19
18b
21a
20
18a
17
15a
11
15c 14b 13b 15b
16b
12

EP 1 662 551 A2

## FIG. 4A

22
21a
20

IVb

18a

19
17
14a
13a  16a
15a

12

IVb

## FIG. 4B

19
18b

22
21a
20
18a
17

15a

11

15c 14b 13b 15b          12

16b

## FIG. 4C

IVd

22
23  21
20

19
17

18a

14a
13a  16a
15a

12

IVd

11

## FIG. 4D

19
18b

22
21  23
20
18a
17

15a

11

15c 14b 13b 15b          12

16b

EP 1 662 551 A2

FIG. 5A

FIG. 5B

FIG. 6A

6a          6a          6a

21b

20

FIG. 6B

6b      6c      6d      6e      6f

21a

20

# FIG. 7

# FIG. 8

## FIG. 9A

## FIG. 9B

## FIG. 9C

## FIG. 10A

39a
41a
40
38

39
37
34
33 } 36
35
31

32

## FIG. 10B

39a
42
41a
40
38

39
37
34
33 } 36
35
31

32

## FIG. 10C

39a
42
43 { 41
40
38

39
37
34
33 } 36
35
31

32